# EUROPÄISCHE PATENTSCHRIFT

(11) **EP 1 148 542 B1**
(45) Veröffentlichungstag und Bekanntmachung des Hinweises auf die Patenterteilung: **29.11.2006**
(21) Anmeldenummer: 01107218.8
(22) Anmeldetag: 23.03.2001
(51) Int. Cl.: H01L 21/768, H01L 23/525

(54) **Verfahren zum Herstellen einer Verdrahtungsebene auf einem Halbleiterchip mit einer Antifuse**
Process for the fabrication of an interconnection level in a semiconductor chip having an antifuse
Procédé pour la fabrication d'un niveau d'interconnexion dans une puce semiconductrice avec antifusible

(30) Priorität: 20.04.2000 DE 10021098
(43) Veröffentlichungstag der Anmeldung: 24.10.2001
(73) Patentinhaber: Infineon Technologies AG, 81669 München (DE)
(72) Erfinder: Lehr, Matthias, Dr., 01099 Dresden (DE); Leiberg, Wolfgang, 01309 Dresden (DE)
(74) Vertreter: Patentanwaltskanzlei WILHELM & BECK

(56) Entgegenhaltungen:
- US-A- 5 552 627
- US-A- 5 877 076

## Beschreibung

Die Erfindung betrifft ein Verfahren zum Herstellen einer Verdrahtungsebene von Schaltelementen auf einem Halbleiterchip mit einer Antifuse.

Antifuses werden als programmierbare Bauelemente in integrierten Schaltungen eingesetzt, um dem Anwender die Möglichkeit zu geben, Funktionen der Schaltung selbst zu programmieren. Weiterhin dienen Antifuses in Halbleiterspeichern zur Schaltungsredundanz, d. h. um z. B. bei einer Datenspeicherzelle durch Aktivierung der Antifuse eine redundante Speicherzelle zuzuschalten.

Antifuses bestehen dabei im allgemeinen aus zwei elektrisch leitenden Kontakten, zwischen denen eine isolierende Schicht eingebracht ist (z.B. US 5,763,898). Das Material der isolierenden Schicht wird dabei so gewählt, dass es durch Einwirkung von Energie, z.B. durch Einstrahlen eines Laserstrahls bzw. Anlegen einer hohen Spannung an den elektrisch leitenden Kontakten zerstört wird, wodurch eine leitende Verbindung durch die ursprünglich isolierende Schicht entsteht und so die beiden äußeren leitenden Kontakte kurz geschlossen werden. Die Antifuse kann also durch Energieeinwirkung programmiert aus dem Aus-Zustand in den Ein-Zustand geschaltet werden.

Antifuses können dabei aus unterschiedlichsten elektrischen leitenden Materialien als Kontakte sowie aus unterschiedlichsten zwischen diesen Kontakten angeordneten isolierenden Zwischenschichten hergestellt werden. Bevorzugt ist jedoch die Herstellung der Antifuses im Rahmen der Ausbildung der Metallebenen im Halbleiterchip zum Verdrahten der Schaltelemente der integrierten Schaltung bzw. zum Verbinden dieser Komponenten mit den äußeren Anschlüssen des Halbleiterchips. Herkömmlicherweise wird dabei folgender Prozessablauf zum Ausbilden von Antifuses im Rahmen einer Metallisierung des Halbleiterchips durchgeführt: Zur Herstellung der Verdrahtungsebene wird auf dem Halbleiterchip eine Oxidschicht aufgetragen, auf der mittels Photolithographie Kontaktlöcher zu den Bauelementen im Halbleiterchip festgelegt werden. An diesen Kontaktstellen wird dann vorzugsweise durch chemischphysikalisches Trockenätzen das Oxid abgetragen. Die freigelegten Kontaktlöcher werden mit einem leitenden Material, z.B. Polysilicium oder einem Metall aufgefüllt. Das Füllmaterial wird anschließend durch Rückätzen außerhalb der Kontaktlöcher wieder entfernt, wobei sich in den Kontaktlöchern Vertiefungen bilden. Dann wird eine dielektrische Schicht, vorzugsweise Siliciumnitrid, Siliciumdioxid oder Siliciumoxynitrid, abgeschieden, auf der in einem weiteren Lithographieprozess die Leiterbahnen definiert werden. Bei diesem Lithographieprozess wird zuerst ein aus zwei Schichten bestehender Photolack auf die dielektrische Schicht aufgeschleudert. Dieser Zwei-Schichten-Photolack besteht aus einer unteren organischen Antireflexionsschicht, die ein Photoresist oder dessen Harz sein kann, der durch einen Absorberzusatz oder durch ein Ausheizen stark lichtabsorbierend gemacht ist. Auf diese organische Antireflexionsschicht ist dann die eigentlich photochemisch aktive Photolackschicht aufgebracht. Die untere organische Antireflexionsschicht dient dazu, dass praktisch kein Licht von der Halbleiteroberfläche in die obere lichtempfindliche Photolackschicht zurückreflexiert wird, wodurch Interferenzeffekte, die ein profilgenaues Übertragen der Maskenstruktur beim Belichten auf den Photolack verhindert, vermieden werden.

Nach dem Belichten wird die obere Photolackschicht entwickelt, wobei die bestrahlten Bereiche des Photolacks entfernt werden. Die verbleibenden Photolackbereich dienen als Ätzmaske zum anisotropen Ätzen der organischen Antireflexionsschicht, um die in der oberen Photolackschicht erzeugte Struktur auf die unter der organischen Antireflexionsschicht liegende dielektrische Schicht zu übertragen. Anschließend wird dann in einem nächsten Ätzschritt, bei der die organische Antireflexionsschicht als Maske dient, die dielektrische Schicht und Teile des darunterliegenden Materials entfernt, so dass Leiterbahngräben entstehen. Dann wird der gesamte verbleibende Photolack entfernt und großflächig ein metallischer Werkstoff, vor allem Wolfram, auf der Oberfläche abgeschieden, wobei die als Leiterbahnen dienenden geätzten Gräben und auch die mit einer dielektrischen Schicht bedeckten Vertiefungen in den übrigen Kontaktlöcher, in die keine Leiterbahn geätzt wurden, aufgefüllt werden. Anschließend wird dann das metallische Material außerhalb der Gräben und dieser Vertiefungen in den Kontaktlöcher wieder entfernt. Die mit dem leitenden Material aufgefüllten Gräben dienen als Leiterbahnen zum Verdrahten der Bauelemente des Halbleiterchips, während die aufgefüllten Kontaktlöcher mit der zwischen den leitenden Materialien liegenden dielektrischen Schicht als Antifuses verwendet werden.

Beim herkömmlichen Prozessablauf zur Herstellung von Antifuses im Rahmen der Metallisierung müssen zur Ausbildung der Leiterbahnen, wie erläutert, zwei Ätzungen ausgeführt werden, wobei zuerst die organische Antireflexionsschicht und anschließend die darunterliegende dielektrische Schicht, die als Antifuse-Dielektrikum benötigt wird, entfernt wird. Bei der Ätzung der organischen Antireflexionsschicht muss dabei insbesondere auch das in den Kontaktlöchern auf der die lektrischen Schicht abgeschiedene Material zuverlässig entfernt werden, was nur durch eine sehr präzise Prozessführung möglich ist. Bei den aufeinanderfolgenden Ätzungen der organischen Antireflexionsschicht und der dielektrischen Schicht muss darüber hinaus darauf geachtet werden, dass eine Verträglichkeit zwischen den verschiedenen Ätzprozessen erreicht wird, andernfalls müssen die beiden Ätzvorgänge in zwei verschiedenen Reaktionskammer ausgeführt werden, wodurch sich die Herstellungskosten wesentlich erhöhen.

Ein Verfahren zum Herstellen einer Anitifuse auf einem Halbleiterchip ist aus der US-A-5 552 627 bekannt. In der US-A-5 877 076 wird ein Verfahren zur Herstellung von Kontakten in Dual-Damascene-Technik beschrieben.

Aufgabe der vorliegenden Erfindung ist es ein Verfahren zum Herstellen von Leiterbahnen auf einem Halbleiterchip mit einem Antifuse bereitzustellen, dass sich durch eine einfache Prozessführung und niedrige Herstellungskosten auszeichnet.

Die Aufgabe wird mit einem Verfahren nach Anspruch 1 gelöst. Bevorzugte Ausführungsformen sind in den abhängigen Ansprüchen angegeben.

Beim erfindungsgemäßen Verfahren zum Herstellen von Leiterbahnen auf einem Halbleiterchip mit einer Antifuse werden folgende Verfahrensschritte nacheinander ausgeführt:
a) Aufbringen einer Dielektrikumsschicht mit einer vergrabenen Antireflexionsschicht auf der Chipoberfläche;
b) Photolithographie zum Definieren von Kontaktlöchern in der Dielektrikumsschicht;
c) Ätzen der Kontaktlöcher in die Dielektrikumsschicht bis zur Chipoberfläche;
d) großflächiges Aufbringen von leitendem Material auf der Oberfläche und Beseitigen dieses Materials außerhalb der Kontaktlöcher, wobei Vertiefungen über den Kontaktlöchern entstehen;
e) großflächiges Aufbringen einer isolierenden Schicht auf der Oberfläche;
f) Photolithographie zum Definieren von Leiterbahnen im Bereich einzelner Kontaktlöcher auf der isolierenden Schicht;
g) Ätzen von Leiterbahngräben in die isolierende Schicht und die darunterliegende Dielektrikumsschicht bis zur vergrabenen Antireflexionsschicht; und
h) großflächiges Aufbringen von leitendem Material auf der Oberfläche und Beseitigen dieses Materials außerhalb der Leitungsbahngräben und der Vertiefungen über den Kontaktlöchern.

Diese Prozessführung zum gleichzeitigen Ausbilden von Leiterbahnen und Antifuses, die beide im Bereich von Vertiefungen in den Kontaktlöcher ausgebildet werden, ermöglicht es die Ätzung der Leiterbahnen in einem einzigen Ätzschritt, bei der die isolierende Schicht in den für die Leiterbahnen vorgesehenen Bereich abgetragen wird, auszuführen, wodurch sich ein vereinfachter und kostengünstiger Prozessverlauf ergibt. Die in der Dielektriumsschicht vergrabene Antireflexionsschicht sorgt dabei zuverlässig dafür, dass bei der Photolithographie zum Definieren sowohl der Kontaktlöcher als auch der Leiterbahnen Interferenzeffekte beim Belichten vermieden werden.

Gemäß einer bevorzugten Ausführungsform besteht die vergrabene Antireflexionsschicht aus einem lichtabsorbierenden anorganischen Material, vorzugsweise einem Oxynitrid. Dieser Werkstoff lässt sich besonders gut als Zwischenschicht in ein Dielektrikum, insbesondere ein Oxid, einbauen und zusammen mit diesem Dielektrikum ätzen.

Gemäß einer weiteren bevorzugten Ausführungsform wird als Material zum Auffüllen der Kontaktlöcher Polysilicium, als isolierende Schicht Siliciumnitrid und als leitendes Material in den Vertiefungen der Kontaktlöcher Wolfram eingesetzt. Mit dieser Schichtenfolge lässt sich mit Hilfe der bekannten Standardprozessführung im Rahmen der Metallisierung zuverlässig eine Antifuse mit genau einstellbarer Durchbruchspannung erzielen.

Nachfolgend wird die Erfindung anhand der Zeichnungen näher erläutert. Es zeigen:
- Fig. 1: einen schematischen Querschnitt durch einen Halbleiterchip mit einem herkömmlichen Photolackaufbau zum Strukturieren einer Leiterbahnebene auf dem Chip, wobei gleichzeitig mit der Leiterbahnen Antifuses ausgebildet werden;
- Fig. 2A bis D: schematischen Querschnitte durch einen Halbleiterchip zur Ausbildung von Leiterbahnen und Antifuses in verschiedenen Stadien des erfindungsgemäßen Prozessverlaufes.

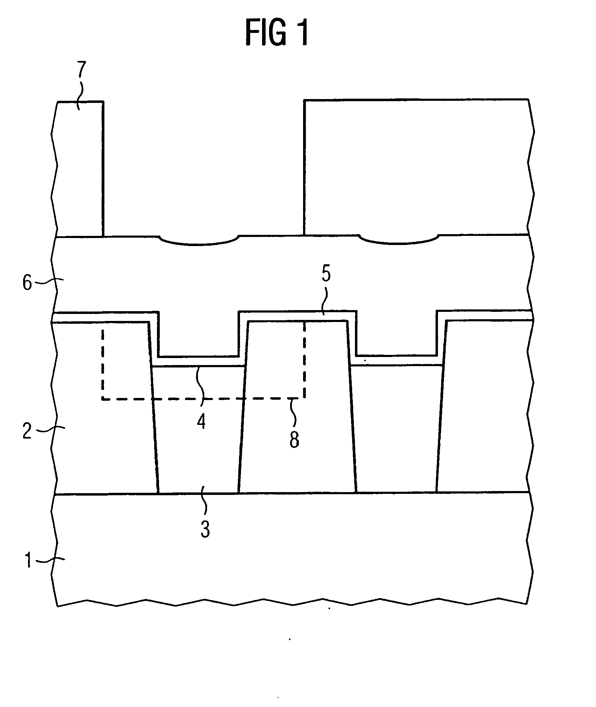

Beim herkömmlichen Prozessverlauf zur Ausbildung von Antifuses im Rahmen der Herstellung der ersten Metallisierungsebene, wie er in Fig. 1 gezeigt ist, erfolgt die Photolithographie zum Definieren der verschiedenen Strukturen mit einer Photolackschichtenfolge aus einer unten liegenden organischen Antireflexionsschicht und einer darüber aufgebrachten photochemisch aktiven Lackschicht. Die organische Antireflexionsschicht kann dabei ein Photoresist oder dessen Harz sein, das durch einen Absorberzusatz oder Aufheizen stark lichtabsorbierend gemacht ist und so dafür sorgt, dass praktisch kein Licht von der Halbleiteroberfläche in die obere photochemisch aktive Lackschicht zurück reflexiert wird, wodurch zuverlässig Interferenzeffekte bei der Lackbelichtung vermieden werden.

Es ergibt sich dabei folgender Schichtenaufbau bei der Leiterbahnätzung nach dem herkömmlichen Prozessvorlauf: Auf den Halbleiterchip 1 ist eine dicke Siliciumdioxidschicht 2 aufgetragen, in der in einem vorhergehenden Lithographieschritt Kontaktlöcher 3 strukturiert sind, die mit dotierten Polysilicium als leitendem Material aufgefüllt sind. Diese Kontaktlöcher 3 mit dem Polysilicium weisen Vertiefungen 4 gegenüber der Oxidoberfläche auf, die durch Rückätzen des Polysiliciums entstehen. Über dem Siliciumdioxid 2 und dem Polysilicium der Kontaktlöcher 3 ist eine dünne Siliciumnitridschicht 5 als zusätzliche dielektrische Schicht aufgetragen.

Zur Photolithographie der Leiterbahnen wird dann der Halbleiterchip belackt, wobei ein Lackaufbau mit der unten liegenden organischen Antireflexionsschicht 6 und der oben liegenden photochemisch aktiven Lackschicht 7 ausgebildet ist. Zum Definieren der Leiterbahnen wird das Photolacksystem in den dafür vorgesehenen Bereichen belichtet und entwickelt, wobei sich die obere photochemisch aktive Schicht 7 in den Leiterbahnenbereichen ablöst. Die zum Ausbilden der Antifuses vorgesehenen Kontaktlöcher bleiben dagegen weiter mit dem kompletten Photolacksystem maskiert. Um nun die Leiterbahnen auf dem Halbleiterchip zu strukturieren, wird durch eine anisotrope Ätzung, die herkömmlicherweise mit Hilfe des reaktiven Ionenätzverfahren durchgeführt wird, in einem ersten Ätzschritt die organische Antireflexionsschicht 6 abgeätzt, um die Leiterbahnstruktur auf die darunterliegende Siliciumnitridschicht 5 zu übertragen.

In einem zweiten Ätzschritt wird dann die Nitridschicht 5 und ein Teil der darunterliegenden Oxidschicht bzw. der Polysiliciumschicht in den Kontaktlöchern anisotrop weggeätzt, um Gräben 8 für die Leiterbahnen (gestrichelt) auszubilden. Für die beiden Ätzschritte, d. h. das Wegätzen der organischen Antireflexionsschicht und die anschließende Nitridätzung bzw. Oxid- und Polysiliciumätzung zur Grabenbildung müssen unterschiedliche Ätzgaszusammensetzungen verwendet werden. Weiterhin stellt sich insbesondere eine genaue Prozessführung zum Wegätzen des gesamten Materials der organischen Antireflexionsschicht über die Nitridschicht in den Vertiefungen 4 der Kontaktlöcher 3 als schwierig dar. Mit der herkömmlichen Prozessführung ist es deshalb aufwendig und damit teuer, die Leiterbahngräben herzustellen.

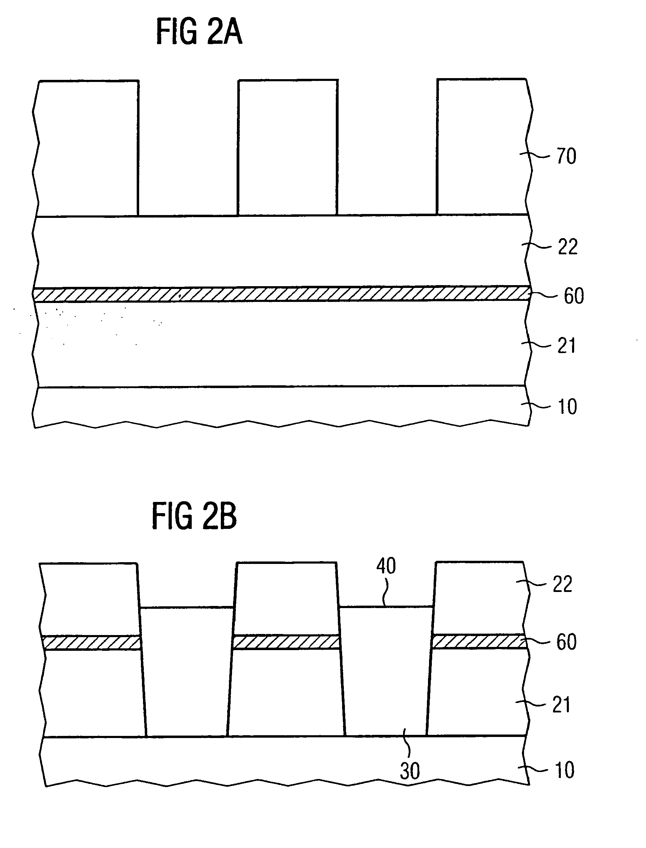

Um die kritische Leiterbahngrabenätzung mit zwei aufeinanderfolgenden Ätzschritten zu vermeiden, wird gemäß der Erfindung ein Prozessablauf zur kombinierten Herstellung einer ersten Verdrahtungsebene und von Antifuses auf dem Halbleiterchip mit einer veränderten Lackschichtenzusammensetzung eingesetzt. Fig. 2A - D zeigt einzelne Prozessschritte im erfindungsgemäßen Herstellungsverfahren. Die erfindungsgemäße Prozessfolge beginnt mit der Abscheidung einer Planarisierungsschicht 21 auf der Scheibenoberfläche 10. Mit dieser Planarisierungsschicht 21 sollen Kanten und Stufen auf der Scheibenoberfläche, die insbesondere durch Polysilicium-Gates der bereits strukturierten Bauelemente entstehen, vor dem Aufbringen der Metallisierung beseitigt werden. Zur Planarisierung werden vorzugsweise in Reflow-Technik aufgebrachte dotierte Gläser eingesetzt, wobei vor allem eine Phosphor (PSG) oder eine Bor-Phosphor (BPSG) Dotierung gewählt wird. Nach dem Abscheiden dieser Gläser erfolgt ein Hochtemperaturschritt, wodurch steile Kanten auf der Scheibenoberfläche 1 infolge der Oberflächenspannung des aufgeschmolzenen Glases abgeflacht und eine sanft geschwungene Oberfläche entsteht. Alternativ zu den genannten dotieren Gläsern besteht auch die Möglichkeit, insbesondere dann, wenn die Prozesstemperatur für das Aufschmelzen der Gläser zu einer Beschädigung der darunterliegenden Halbleiterbauteile führen würde, andere Planarisierungsschichten, z. B. Spin-On-Gläser, einzusetzen.

Auf die dotierte Glasschicht 21 wird eine dünne anorganische Antireflexionsschicht 60 aufgetragen, die vorzugsweise aus Oxynitrid besteht und eine Dicke von 15 bis 60 µm besitzt. Diese anorganische Antireflexionsschicht 60 ist so ausgelegt, dass das zur Photolithographie eingesetzte, vorzugsweise in Ultraviolett liegende Licht in dieser Schicht nahezu vollständig absorbiert wird. Auf die anorganische Antireflexionsschicht 60 wird dann eine dielektrische Schicht 22, vorzugsweise Siliciumdioxid z. B. nach dem TEOS-Verfahren abgeschieden. Alternativ besteht jedoch auch die Möglichkeit, die anorganische Antireflexionsschicht als Zwischenschicht in die dielektrische Schicht einzubauen.

Die Siliciumdioxidschicht 22 wird anschließend mit einem strahlungsempfindlichen Photolack 70 beschichtet. Gebräuchliche Photolacke sind dabei Positivresiste, die im wesentlichen aus drei Bestandteilen bestehen, nämlich einer Harzverbindung, die für die Schichtenbildung verantwortlich ist, einer photoaktiven Verbindung sowie einem Lösungsmittel. Nachdem Aufschleudern des Photolacks wird das Lösungsmittel aus dem Lack durch Vorbacken ausgetrieben. Anschließend wird der Lack 70 dann über eine Maske, die das Muster der gewünschten Kontaktlöcher zu den Bauelementen auf dem Halbleiterchip vorzugsweise als Chromschicht auf einem transparenten Träger enthält, belichtet. Bei diesem Belichtungsvorgang sorgt die anorganische Antireflexionsschicht 60, die als Zwischenschicht unter der Siliciumdioxidschicht 22 vorgesehen ist, dafür, dass praktisch kein Licht von der Chipoberfläche in den Photolack 70 zurückreflexiert wird und so zuverlässig belichtungsstörende Interferenzeffekte vermieden werden.

Nach dem Belichten wird der Photolack 70 dann entwickelt, wobei bei dem herkömmlicherweise eingesetzten Positivlacken mit Laugen die bestrahlten Bereiche abgetragen werden. Anschließend wird dann, um für den nachfolgenden Ätzprozess die notwendige Resistenz des Lackes zu erzielen, der Lack durch Nachbacken gehärtet. Fig. 2A zeigt den Schichtenaufbau nach diesen Prozessschritt.

Zum Öffnen der Kontaktlöcher 30 wird eine anisotrope Ätzung der Schichtenfolge aus dotierter Glasschicht 21, anorganischer Antireflexionsschicht 60 und Siliciumdioxidschicht 22 durchgeführt, so dass die im Photolack 70 erzeugte Struktur auf die unter der dotierten Glasschicht liegende Oberfläche 10 des Halbleiterchips übertragen wird. Die Ätzung erfolgt dabei vorzugsweise mit Hilfe chemisch-physikalischem Trockenätzens, insbesondere nach dem reaktiven Ionenätz-Verfahren, mit dem sich eine hohe Selektivität und ein guter Anisotropiefaktor erreichen lassen. Bei diesem Ätzvorgang dient die verbleibende Photolackschicht als Ätzmaske.

Die Photolackschicht wird dann nach Abschluss des Ätzvorgangs komplett abgelöst. Anschließend werden die Kontaktlöcher 30 mit einem leitenden Material aufgefüllt. Als leitendes Material wird hierbei vorzugsweise dotiertes Polysilicium eingesetzt, das sich insbesondere zur Herstellung von überlappenden (borderless) Kontakten zwischen verschiedenen Bauteilen auf dem Halbleiterchip eignet. Es besteht jedoch auch die Möglichkeit, statt Polysilicium Metalle wie z.B. Wolfram oder Kupfer einzusetzen. Nach dem Auffüllen der Kontaktlöcher 30 wird die Polysiliciumschicht außerhalb der Kontaktlöcher durch Rückätzen entfernt, wobei die Planarisierung so durchgeführt wird, dass Vertiefungen 40 im Bereich der Kontaktlöcher 30 gegenüber der umliegenden Siliciumdioxidschicht 22 entstehen. Fig. 2B zeigt den Herstellungsprozess nach Abschluss dieses Prozessschrittes.

Nach dieser Planarisierung des Polysiliciums in den Kontaktlöchern 30 wird großflächig eine Siliciumnitridschicht 50 auf der Oberfläche abgeschieden. Diese Siliciumnitridschicht ist elektrisch isolierend und wird als Mittelschicht im Antifuseaufbau eingesetzt. Statt Siliciumnitrid kann jedoch auch ein anderes elektrisch isolierendes Material verwendet werden. Durch die Dicke dieser Isolationsschicht bzw. das eingesetzte Material kann dabei die Durchbruchsspannung zum Schalten der Antifuse aus dem Aus-Zustand in den Ein-Zustand festgelegt werden.

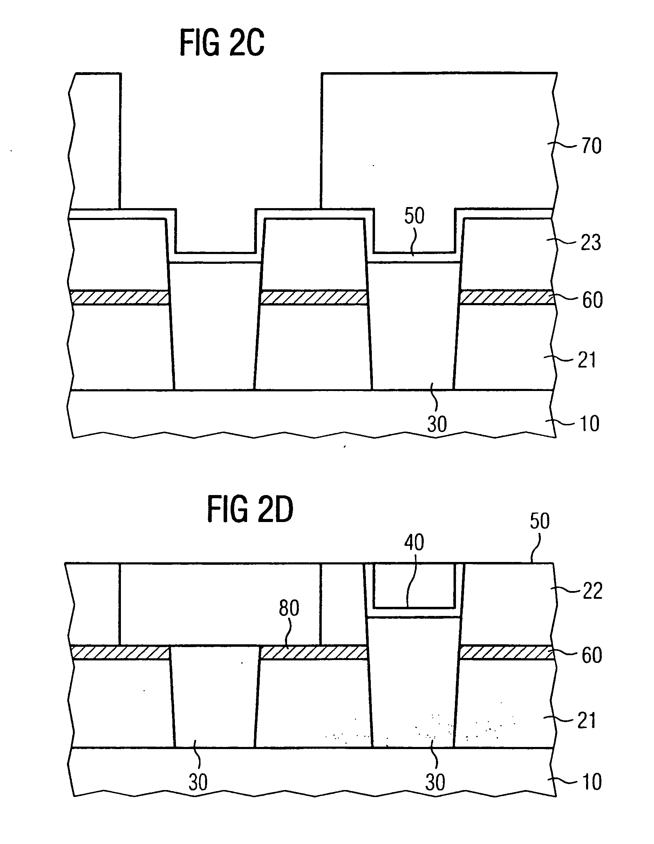

Nach dem Aufbringen der Siliciumnitridschicht 50 wird dann ein weiterer Lithographieprozess zum Definieren der Leiterbahnen durchgeführt. Hierzu wird auf die Siliciumnitridschicht 50 wiederum eine lichtempfindliche Photolackschicht 70 aufgeschleudert, die dann mit einer Maske, die die Struktur der Leiterbahnen enthält, belichtet wird. Anschließend wird die Photolackschicht 70 entwickelt, wodurch der Photolack an den belichteten Stellen abgetragen wird. Fig. 2C zeigt den Schichtenaufbau nach dem auf das Entwickeln folgende Härten der stehengebliebenen Photolackbereich. Wie in Fig. 2C dargestellt ist, ist der Photolack dabei über Kontaktlöchern, die über die Leiterbahnen verbunden werden sollen, geöffnet. Die Kontaktlöcher dagegen, in denen die Antifuses ausgebildet werden sollen, sind weiterhin durch den Photolack maskiert.

Zum Ausbilden der Leiterbahngräben 80 erfolgt dann wiederum, vorzugsweise in chemisch-physikalischer Trockenätz-Technik, ein Ätzprozess, bei dem die Photolackschicht 70 als Ätzmaske dient. Hierbei wird anisotrop zuerst die Siliciumnitridschicht 50 und anschließend die darunterliegende Siliciumdioxidschicht 23 weggeätzt, wobei die anorganische Antireflexionsschicht 60 als Ätzstop dient. Bei diesen Vorgang wird im Bereich der Kontaktlöcher 30 auch teilweise das eingefüllte Polysilicium entfernt. Dieser Ätzvorgang stellt einen bekannten Standardprozess dar, der vorzugsweise mit Hilfe des reaktiven Ionenätzens ausgeführt wird.

Nach Abschluss des Ätzvorgangs wird dann die Photolackschicht 70 komplett beseitigt und eine dünne Haftvermittler-Zwischenschicht und eine Metallschicht großflächig auf der freigelegten Oberfläche aufgetragen, wobei sich die durch die Ätzung entstandenen Leiterbahngräben 80 sowie die über den Kontaktlöchern 30 auf der Siliciumnitridschicht vorhandenen Vertiefungen 40 füllen. Als Haftvermittler wird dabei vorzugsweise Titan und als Metall Wolfram eingesetzt. Vorzugsweise durch chemisch-mechanisches Polieren wird die Haftvermittlerschicht und die Metallschicht außerhalb der Gräben 80 und Vertiefungen 40 wieder entfernt, so dass eine plane Oberfläche entsteht. Der Schichtenaufbau nach diesem Prozessschritt ist in Fig. 2D gezeigt.

Im Halbleiterchip sind dann sowohl Leiterbahnen, die über Kontaktlöcher mit den Bauelementen auf dem Halbleiterchip verbunden sind, sowie Antifuses entstanden. Diese Antifuses werden durch die Kontaktlöcher gebildet, bei denen zwischen der dotieren Polysiliciumschicht und der darüberliegenden Metallschicht weiterhin die isolierende Siliciumnitridschicht 50 vorhanden ist.

Mit dem erfindungsgemäßen Prozessablauf können also im Rahmen der Ausbildung einer Verdrahtungsebene gleichzeitig Antifuses ausgebildet werden, die als programmierbare Bauelemente dem Anwender die Möglichkeit geben, Funktionen auf dem Halbleiterchip durch Aktivieren der Antifuses, d. h. Anlegen einer Durchbruchspannung, eigenhändig anzuschalten. Die dargestellte Prozessfolge kann dabei auch wiederholt angewendet werden, so dass eine Mehrlagenverdrahtung mit Antifuses in den verschiedenen Ebenen ausgeführt werden kann.

### Bezugszeichenliste

- 1: Halbleiterchipoberfläche
- 2: Dielektrikum
- 3: Kontaktlöcher
- 4: Vertiefungen
- 5: isolierende Schicht
- 6: organische Antireflexionsschicht
- 7: Photolackschicht
- 8: Leiterbahngräben
- 10: Halbleiterchipoberfläche
- 21: dotierte Glasschicht
- 22: Siliciumdioxidschicht
- 30: Kontaktlöcher
- 40: Vertiefungen
- 50: isolierende Schicht
- 60: anorganische Antireflektionsschicht
- 70: Photolackschicht
- 80: Leiterbahngräben

## Patentansprüche

1. Verfahren zum Herstellen von Leiterbahnen auf einem integriertem Halbleiterchip mit einer dielektrischen Antifuse mit folgenden Verfahrensschrittreihenfolge:
a) Aufbringen einer Dielektrikumsschicht mit einer vergrabenen Antireflexionsschicht auf der Chipoberfläche;
b) Photolithographie zum Definieren von Kontaktlöchern in der Dielektrikumsschicht;
c) Ätzen der Kontaktlöcher in die Dielektrikumsschicht bis zur Chipoberfläche;
d) großflächiges Aufbringen von leitendem Material auf der Oberfläche und Beseitigen dieses Materials außerhalb der Kontaktlöcher, wobei Vertiefungen über den Kontaktlöchern entstehen;
e) großflächiges Aufbringen einer isolierenden Schicht auf der Oberfläche;
f) Photolithographie zum Definieren von Leiterbahnen im Bereich einzelner Kontaktlöcher auf der isolierenden Schicht;
g) Ätzen von Leiterbahngräben in die isolierende Schicht und die darunterliegende Dielektrikumsschicht bis zur vergrabenen Antireflexionsschicht; und
h) großflächiges Aufbringen von leitendem Material auf der Oberfläche und Beseitigen dieses Materials außerhalb der Leitungsbahngräben und der Vertiefungen über den Kontaktlöchern.

2. Verfahren gemäß Anspruch 1, wobei als vergrabene Antireflexionsschicht vorzugsweise ein lichtabsorbierendes anorganisches Material, insbesondere Oxynitrid, eingesetzt wird.

3. Verfahren nach Anspruch 1 oder 2, wobei die Dicke der Antireflexionsschicht vorzugsweise 15 bis 60 µm beträgt.

4. Verfahren nach einem der Ansprüche 1 bis 3, wobei für die isolierende Schicht Siliciumnitrid eingesetzt wird.

5. Verfahren gemäß einem der Ansprüche 1 bis 4, wobei als Auffüllmaterial für die Kontaktlöcher dotiertes Polysilicium und als Material zum Auffüllen der Leitungsbahngräben und der Vertiefungen über den Kontaktlöchern Wolfram eingesetzt wird.

## Claims

1. Method for fabricating interconnects on an integrated semiconductor chip with a dielectric antifuse, having the following order of method steps:
a) application of a dielectric layer with a buried antireflection layer on the chip surface;
b) photolithography for defining contact holes in the dielectric layer;
c) etching of the contact holes into the dielectric layer as far as the chip surface;
d) large-area application of conductive material on the surface and elimination of this material outside the contact holes, depressions being produced above the contact holes;
e) large-area application of an insulating layer on the surface;
f) photolithography for defining interconnects in the region of individual contact holes on the insulating layer;
g) etching of interconnect trenches into the insulating layer and the underlying dielectric layer as far as the buried antireflection layer; and
h) large-area application of conductive material on the surface and elimination of this material outside the interconnect trenches and the depressions above the contact holes.

2. Method according to Claim 1, preferably a light-absorbing inorganic material, in particular oxynitride, being used as the buried antireflection layer.

3. Method according to Claim 1 or 2, the thickness of the antireflection layer preferably being 15 to 60 µm.

4. Method according to one of Claims 1 to 3, silicon nitride being used for the insulating layer.

5. Method according to one of Claims 1 to 4, doped polysilicon being used as a filling material for the contact holes and tungsten being used as a material for filling the interconnect trenches and the depressions above the contact holes.

## Revendications

1. Procédé de fabrication de voies conductrices sur une puce semi-conductrice intégrée comportant un antifusible diélectrique, avec la succession suivante d'étapes de procédé :
a) application sur la surface de la puce d'une couche diélectrique avec une couche antiréflexion enfouie ;
b) photolithographie pour la définition de trous de contact dans la couche diélectrique ;
c) gravure des trous de contact dans la couche diélectrique jusqu'à la surface de la puce ;
d) application de matériau conducteur sur une grande étendue de la surface, et élimination de ce matériau hors des trous de contact, des renfoncements étant en l'occurrence engendrés au-dessus des trous de contact ;
e) application d'une couche d'isolation sur une grande étendue de la surface ;
f) photolithographie pour la définition de voies conductrices dans la zone de différents trous de contact sur la couche d'isolation ;
g) gravure de sillons de voies conductrices dans la couche d'isolation et dans la couche diélectrique située au-dessous, jusqu'à la couche antiréflexion enfouie ; et
h) application de matériau conducteur sur une grande étendue de la surface, et élimination de ce matériau hors des sillons des voies conductrices et des renfoncements au-dessus des trous de contact.

2. Procédé selon la revendication 1, où un matériau inorganique absorbant la lumière, notamment de l'oxynitrure, est utilisé en tant que couche antiréflexion enfouie.

3. Procédé selon la revendication 1 ou 2, où l'épaisseur de la couche antiréflexion est de préférence de 15 à 60 µm.

4. Procédé selon l'une des revendications 1 à 3, où du nitrure de silicium est utilisé pour la couche d'isolation.

5. Procédé selon l'une des revendications 1 à 4, où du polysilicium dopé est utilisé en tant que matériau de remplissage des trous de contact, et du tungstène en tant que matériau de remplissage des sillons des voies conductrices et des renfoncements au-dessus des trous de contact.
